# EUROPÄISCHE PATENTSCHRIFT

(11) **EP 0 751 562 B1**
(45) Veröffentlichungstag und Bekanntmachung des Hinweises auf die Patenterteilung: **18.07.2001**
(21) Anmeldenummer: 96106943.2
(22) Anmeldetag: 03.05.1996
(51) Int. Cl.: H01L 23/367

(54) **Wärmeleite-Befestigung eines elektronischen Leistungsbauelementes auf einer Leiterplatte mit Kühlblech**
Thermally conducting fastening of an electronic power device to a printed circuit board with a heat dissipator
Fixation thermiquement conductive d'un dispositif électronique de puissance sur une plaquette de circuit avec dissipateur de chaleur

(30) Priorität: 27.06.1995 DE 19523366; 08.09.1995 DE 19533251
(43) Veröffentlichungstag der Anmeldung: 02.01.1997
(73) Patentinhaber: Braun GmbH, Kronberg (DE)
(72) Erfinder: Hiller, Hans-Martin, 61381 Friedrichsdorf (DE); Stratmann, Martin, 60318 Frankfurt am Main (DE); Werhahn, Friedrich, 97828 Marktheidenfeld (DE); Debus, Wolfram, 61476 Kronberg (DE); Oppermann, Günter, 63128 Dietzenbach (DE)

(56) Entgegenhaltungen:
- DE-A- 4 102 265
- DE-A- 4 204 391
- DE-A- 4 226 168
- DE-A- 4 330 975
- US-A- 3 825 803
- US-A- 4 924 352
- US-A- 5 014 904

## Beschreibung

Die vorliegende Erfindung betrifft ein Verfahren zur wärmeleitenden Befestigung eines elektronischen Bauelementes auf einer Leiterplatte in Verbindung mit einem Kühlblech oder Kühlkörper zur Wärmeabfuhr.

Es ist einerseits bereits ein gattungsgemäßes Verfahren bekannt, SMD-Leistungshalbleiter direkt auf eine doppelseitig kaschierte, durchkontaktierte Leiterplatte zu kleben und anschließend eine elektrische Kontaktierung der Anschlüsse durch Löten herzustellen. Die Wärme wird hierbei über die metallisierten Bohrungen unter den Leistungsbauelementen auf die Rückseite der Leiterplatte geführt und dort abgeleitet. Dort befindet sich meistens ein z.B. durch Kleben befestigter Kühlkörper zur Erhöhung der Wärmekapazität und Vergrößerung der Wärmeabgabefläche.

Es ist weiterhin ein Verfahren bekannt, bei dem ein elektronisches Leistungsbauelement, wie z.B. eine Diode, ein Transistor, ein Thyristor oder ein Triac, an einem Kühlblech befestigt ist. Diese Befestigung erfolgt dabei beispielsweise mittels Vernieten, Verschrauben oder mittels eines Klemmbügels. Das Leistungsbauelement ist mit einem Kühlblech verbunden, um die entstehende Verlustwärme in dem Leistungsbauelement abzuführen. Durch die relativ große Oberfläche des Kühlbleches ist somit eine größere Wärmeabfuhr pro Zeiteinheit möglich, als wenn das Leistungsbauelement nicht mit einem Kühlblech verbunden ist. Eine wärmeleitende Verbindung zwischen dem Leistungsbauelement und dem Kühlblech wird dabei unter Verwendung einer Wärmeleitpaste und Glimmerscheiben herbeigeführt. Es ist auch bereits grundsätzlich bekannt, eine derartige Verbindung durch eine Verlötung herbeizuführen.

Aus der DE 42 04 391 A1 ist eine Leiterkarte bekannt, die auf ihrer einen Seite mit einem SMD-Leistungshalbleiter bestückt ist, und auf ihrer anderen Seite mit einer Wärmesenke in Kontakt steht. Der Leistungshalbleiter ist auf eine metallisierte Fläche auf der Leiterkarte aufgelötet.

Aus der US-A-5,014,904 ist eine Leiterplatte mit Öffnungen bekannt, in die wärmeleitende Blöcke eingesetzt sind. Auf der Unterseite der Leiterplatte ist eine Kühlplatte angeordnet, mit der die Blöcke wärmeleitend verbunden sind. Die Leiterplatte ist auf ihrer Oberseite mit elektronischen Bauelementen bestückt, die mit den wärmeleitenden Blöcken verklebt sind. Die Anschlußdrähte der elektronischen Bauelemente sind mit der Leiterplatte verlötet.

Der vorliegenden Erfindung liegt das Problem zugrunde, daß die wärmeleitende Befestigung eines Leistungsbauelementes möglichst einfach vonstatten gehen soll.

Nach der erfindungsgemäßen Lösung kann dabei ein SMD-Leistungsbauelement oder ein anderes elektronisches Leistungsbauelement im Rahmen eines automatischen Fertigungsprozesses mit geringem Aufwand wärmeleitend befestigt und elektrisch kontaktiert werden. Gleichzeitig wird die vergleichsweise kleine Wärmekapazität der mit Kupfer kaschierten Leiterplatte vergrößert, so daß die Wärmemenge, die beim Betrieb des Leistungsbauelementes entsteht, von dem Leistungsbauelement weg abgeführt werden kann.

US 4 924 352 A beschreibt ein Verfahren zur wärmeleitenden Befestigung eines elektronischen Leistungsbauelements an einem Kühlblech oder Kühlkörper wird das Leistungsbauelement direkt an dem Kühlelement, das ein Kühlblech oder ein Kühlkörper sein kann, angelötet. Vorteilhaft wirkt sich bei der gelöteten Verbindung des Leistungsbauelements mit dem Kühlelement aus, daß sich bei dieser Art der Befestigung des Leistungsbauelements am Kühlelement ein besonders guter Wärmeübergang ergibt. Dies läßt sich dadurch erklären, daß durch das Löten eine metallische Verbindung zwischen dem Leistungsbauelement und dem Kühlelement realisiert ist, so daß daraus ein guter Wärmeübergang resultiert. Weiterhin entsteht durch die flächige Verlötung des Leistungsbauelementes mit dem Kühlelement eine große Kontaktfläche. Als weiterer Vorteil ergibt sich bei der Montage des Leistungsbauelements auf einer Leiterplatte, daß die gelötete Verbindung des Leistungsbauelements mit dem Kühlelement fertigungstechnisch einfacher zu realisieren ist. Üblicherweise werden nämlich SMD-Bauteile mit sehr geringer Leistung auf eine Leiterplatte aufgebracht und auf dieser Leiterplatte entsprechend dem elektrischen Schaltplan verlötet. Wird nun auch die wärmeleitende Verbindung zwischen dem Leistungsbauelement und einem Kühlelement durch Löten hergestellt, so stellt dies einen weiteren integrierten Vorgang in dem Verfahren zur Herstellung der gesamten Leiterplatte dar. Dies wirkt sich insbesondere bei der automatischen Bestückung der Leiterplatte vorteilhaft aus. Der weitere Lötvorgang ist nämlich verfahrenstechnisch insofern einfacher als die bisher realisierten Verfahren zur wärmeleitenden Befestigung, als dies in einem Arbeitsgang zusammen mit der elektrischen Kontaktierung vorgenommen werden kann.

Die Verlötung des elektronischen Leistungsbauelements mit dem Kühlelement ist einfach realisierbar. Es wird eine sicherere Lötverbindung hergestellt und der Effekt der Oberflächenoxidation kann dadurch weitgehend vermieden werden. Wenn nur ein Teil des Kühlelements, nämlich der Teil, an dem das elektronische Leistungsbauelement an dem Kühlelement angebracht ist, veredelt wird, ergibt sich als weiterer Vorteil, daß der Arbeitsschritt der Veredelung des Kühlelements möglicherweise einfacher durchzuführen ist. Wegen der Größe hat das Kühlelement insgesamt eine relativ große Wärmekapazität. Wenn also das Kühlelement insgesamt in ein Lötbad eingebracht wird, entzieht es diesem Lötbad eine relativ große Wärmemenge. Um daraus resultierende Probleme zu umgehen, ist es vorteilhaft, nur den Teil des Kühlelements zu veredeln, an dem das Leistungsbauelement wirklich festgelötet werden soll. Dadurch wird nur ein geringerer Teil des Kühlelements in das Lötbad eingebracht, so daß auch nur eine geringere Wärmemenge diesem Lötbad entzogen wird. Die Veredelung kann dabei z.B. galvanisch erfolgen.

Wurde die Veredelung beispielsweise durch Verzinnen herbeigeführt, so erreicht diese Veredelung beim Befestigen des Leistungsbauelementes mittels Verlöten wiederum ihren Schmelzpunkt. Vor dem Verlöten wird erfindungsgemäß das Leistungsbauelement punktuell an der Leiterplatte fixiert beispielsweise mittels eines oder mehrerer Klebertropfen, wie dies bei der Bestückung von SMD-Bauteilen bekannt und üblich ist.

Da somit das Leistungsbauelement während des Lötens fixiert ist, kann es wegen der Verflüssigung der Veredelung des Kühlelements nicht "wegschwimmen", d.h. die Fixierung des Leistungsbauelements ist auch bei einem Aufschmelzen der Veredelung während des Lötvorganges gewährleistet. Durch das Versetzen des Leistungsbauelementes in Richtung der Leiterplatte und das Aufkleben auf eine Kante der Leiterplatte - vorteilhaft im Bereich der Anschlußbeinchen des Leistungsbauelementes - entsteht also quasi eine brückenartige Verbindung zwischen der Leiterplatte und dem Kühlelement durch das Leistungsbauelement. Diese Anordnung hat den Vorteil, daß die gesamte Metallisierungsfläche des Leistungsbauelementes zur Wärmeableitung im Betrieb zur Verfügung steht, ohne daß von der Metallisierungsfläche Fläche für die Kleberhaftung auf dem Kühlelement benötigt wird. Der Wärmeübergang von dem Leistungsbauelement auf das Kühlelement wird dadurch also weiter optimiert.

Durch einen Abstandshalter wird erreicht, daß sich während des Lötvorganges definiert ein solcher Abstand zwischen dem Leistungsbauelement und dem Kühlelement einstellt, daß das Lot einfach einbringbar ist. Durch den Abstand zwischen dem Leistungsbauelement und dem Kühlelement wird das flüssige Lot wegen der eintretenden Kapillarwirkung zwischen das Leistungsbauelement und das Kühlelement gezogen. Der Abstand wird dabei vorteilhafter Weise so bestimmt, daß eine möglichst gute Kapillarwirkung für das flüssige Lot zwischen dem Leistungsbauelement und dem Kühlelement eintritt. Es kommt daher zu einer besonders guten flächigen Verlötung von dem Leistungsbauelement und dem Kühlelement, wobei das Lot gleichzeitig einfach von wenigstens einer Seite aus einbringbar ist.

Bei einer automatischen Bestückung ist es vorteilhaft, wenn alle Bauteile einschließlich des elektronischen Leistungsbauelementes in einer Höhe positioniert werden. Das erleichtert die Anbringung mit einem Bestückungsautomaten. Weiterhin ist dadurch, daß sich alle Bauteile auf derselben Höhe befinden, beim Löten zur Herstellung der elektrischen Kontaktierung in einfacher Weise eine Verlötung des bzw. der elektronischen Leistungsbauelemente zu deren wärmeleitender Befestigung möglich, ohne daß die Löteinrichtung aufwendig justiert werden muß. Das Kühlelement kann sich zumindest teilweise in einem Ausschnitt der Leiterplatte befinden oder sich an die Leiterplatte anschließen, d.h. also quasi an der Leiterplatte "anhängen". Das Kühlelement muß dabei entsprechend gebogen sein, daß der Teil des Kühlelements, mittels dem das Kühlelement an der Leiterplatte befestigt wird, sich unterhalb der Leiterplatte befindet. Im Bereich des Ausschnitts der Leiterplatte weist dabei das Kühlelement zumindest dort, wo das Leitungsbauelement befestigt wird, eine Erhebung auf, so daß sich dort die Kühlelementoberfläche mit der Leiterplattenoberfläche in einer Ebene befindet.

Vorteilhaft wirkt sich bei dem erfindungsgemäßen Verfahren aus, wenn das Kühlelement eine sehr gute Wärmeleitfähigkeit aufweist. Dadurch ist nach der Verlötung ein besonders guter Wärmetransport gegeben.

Eine besonders einfache Verlötung des Leistungsbauelements mit dem Kühlelement ist dann gegeben, wenn das Kühlelement vorgeheizt wurde.

Werden die Halterungen des Kühlelements zunächst durch Löcher der Leiterplatte gesteckt und verschränkt, so ist dies vom Herstellungsverfahren gegenüber anderen bekannten Befestigungsarten, wie z.B. Verschrauben oder Vernieten, einfacher durchzuführen.

Bei dem Verfahren nach Anspruch 8 wirkt sich besonders vorteilhaft aus, daß Wärmeausdehnungen des Kühlelements sowie des Leistungsbauelements aufgrund der in dem Leistungsbauelement erzeugten Verlustwärme zu allenfalls geringen mechanischen Verspannungen des Kühlelements sowie des Leistungsbauelements führen. Dadurch, daß das Leistungsbauelement mitsamt dem Kühlelement beispielsweise nur an einer Seite befestigt ist, können sich diese Wärmeausdehnungen in die anderen Richtungen erstrecken, ohne zu Beschädigungen mechanischer oder elektrischer Verbindungen mit der Leiterplatte zu führen.

Bei dem Verfahren nach Anspruch 9 wirkt sich besonders vorteilhaft aus, daß das Kühlelement nochmals verbessert mit der Leiterplatte verbunden wird.

In vorteilhafter Weise kann bei dem Verfahren nach Anspruch 10 ein nach außen geführter Leitungsanschluß des Leistungsbauelementes entfallen. Es ist dann einfacher möglich, zwischen den verbleibenden Leitungsanschlüssen einen Mindestabstand einzuhalten. Es ist beispielsweise möglich, das Leistungsbauelement über das Kühlelement durch die Verlötung mit einem elektrischen Potential der Leiterplatte zu verbinden.

Bei dem Verfahren nach Anspruch 11 zeigt sich, daß eine besonders einfache Kontrolle der Verlötung möglich ist. Durch das Loch in dem Kühlelement, das an einer Stelle angebracht ist, die von der Seite, an der das Lot eingebracht wird, entfernt ist, wird es möglich, eine Kontrolle der Verlötung durchzuführen. Es kann nämlich nur dann Lot durch dieses Loch hindurch austreten, wenn die Fläche zwischen dem Leistungsbauelement und dem Kühlelement zumindest bis zu diesem Loch mit Lot gefüllt ist. Als besonders vorteilhaft hat es sich hierbei erwiesen, wenn die zylindrische Innenfläche des Loches ebenfalls mit einer Veredelungsschicht - wie im Anspruch 1 genannt - mit veredelt ist. Dies ermöglicht in besonders einfacher Weise ein Hindurchtreten des Lotes durch das Loch, wenn das flüssige Lot beim Verlöten dieses Loch erreicht hat.

Mit der Ausführungsform nach Anspruch 12 ist es möglich, bei beengten Platzverhältnissen auf der Leiterplatte eine bestimmte Größe des Kühlelementes zu erreichen, ohne dafür übermäßig viel Platz auf der Leiterplatte selbst zu verbrauchen. Durch die Abwinkelung des Kühlelementes kann dabei eine Größe des Kühlelementes erreicht werden, durch die eine hinreichend große Wärmekapazität sowie eine hinreichend große Wärmeabgabefläche erzielbar ist.

Ein Ausführungsbeispiel der Erfindung ist in der Zeichnung dargestellt. Es zeigt:
- Fig. 1: die Verlötung eines elektronischen Leistungsbauelementes mit einem Kühlelement,
- Fig. 2: die Anbringung des Kühlelementes mit dem Leistungsbauelement auf einer Leiterplatte und
- Fig. 3: eine alternative Ausbildung eines Kühlelementes.

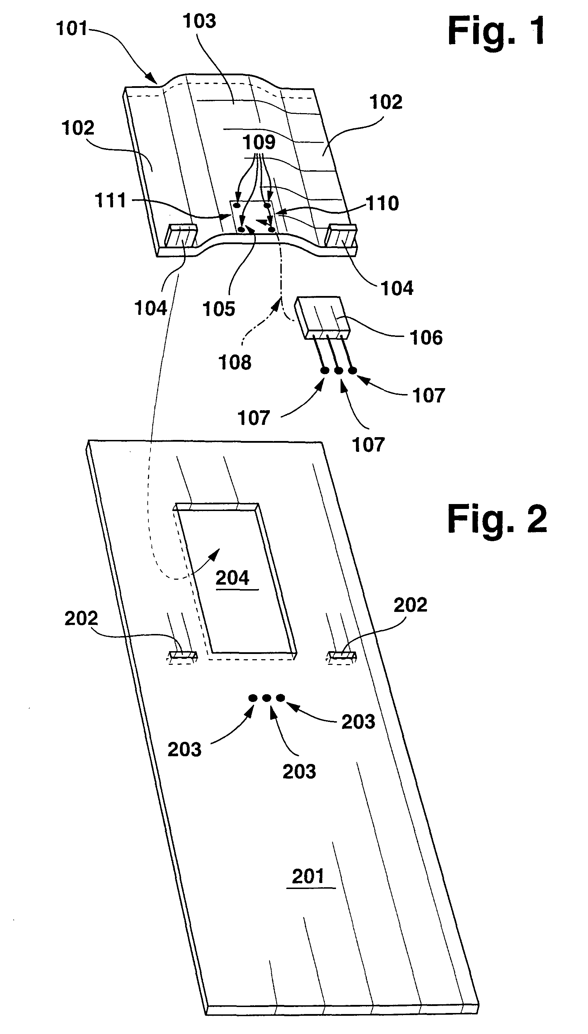

Fig. 1 zeigt ein Kühlelement 101, das ein Kühlblech oder ein Kühlkörper sein kann. Im folgenden Ausführungsbeispiel wird die Erfindung anhand eines Kühlbleches beschrieben. Anstelle des Kühlbleches kann dabei auch ein Kühlkörper Verwendung finden mit einer anderen geometrischen Ausbildung und/oder aus einem anderen Material. Dieses Kühlblech weist zwei äußere Bereiche 102 auf sowie einen mittleren Bereich 103, der gegenüber den äußeren Bereichen 102 erhoben ist. In den beiden Bereichen 102 befindet sich jeweils eine Halterung 104, die von der Fläche des Kühlbleches senkrecht nach oben geht. Das Kühlblech weist dabei einen Bereich 105 auf, an den das Leistungsbauelement 106 angelötet wird. Daß dieses Leistungsbauelement an diesen Bereich angelötet wird, ist durch den Pfeil 108 dargestellt. Das Leistungsbauelement 106 weist dabei elektrische Anschlüsse 107 auf. Durch die Verlötung des Leistungsbauelementes mit dem Kühlblech 101 wird eine metallische Verbindung zwischen dem Leistungsbauelement 106 und dem Kühlblech 101 erzielt. Dadurch findet ein sehr effizienter Wärmeübergang und damit eine sehr gute Abfuhr der in dem Leistungsbauelement erzeugten Verlustwärme statt. Eine besonders gute Abfuhr der Wärme ist dann gegeben, wenn das Kühlblech 101 aus Kupfer, Messing, Weißblech, veredeltem Aluminium o.ä. besteht. Das Verlöten gestaltet sich insbesondere dann besonders einfach, wenn das Kühlblech 101 veredelt, wie z.B. verzinnt ist. Andere Arten der Veredelung können dabei in einer Beschichtung mittels Silber, Gold, Nickel, Palladium und/oder speziellen Lacken bestehen. In vorteilhafter Weise wird dabei nur der Bereich 105 veredelt, an dem das Leistungsbauelement 106 angelötet wird. Durch die relativ große Wärmekapazität des Kühlbleches insgesamt wird bei einer Vollveredelung des Kühlbleches dem Lötbad eine zu große Wärmemenge entzogen. Durch die Veredelung lediglich des Bereiches 105 sind geringere Anforderungen an die Temperaturregelung bei der Verlötung des Kühlbleches zu stellen. Weiterhin ist die Verlötung besonders einfach dann möglich, wenn das Kühlblech 101 zum Zeitpunkt der Verlötung vorgeheizt ist.

Weiterhin hat es sich als besonders vorteilhaft erwiesen, wenn während des Lötvorganges mittels Abstandshaltern 109 ein definierter Abstand zwischen dem Leistungsbauelement 106 und dem Kühlblech 101 hergestellt wird. Diese Abstandshalter 109 können dabei vor dem Lötvorgang aufgelegt werden. Eine andere Möglichkeit der Realisierung besteht darin, daß das Kühlblech 101 an der Unterseite an den entsprechenden Stellen der Abstandshalter 109 mit einer Prägung versehen wird, so daß durch die Materialdeformation des Kühlbleches 101 an den entsprechenden Stellen der Oberseite die Abstandshalter 109 entstehen. Ebenso können diese Abstandshalter aber auch an dem Leistungsbauelement 106 angebracht werden. Mittels dieser Abstandshalter wird dabei während des Lötvorganges ein definierter Abstand zwischen dem Leistungsbauelement 106 und dem Kühlblech 101 eingehalten. Dieser definierte Abstand beträgt dabei vorteilhaft bis zu einer Größenordnung von einem Millimeter und dient dazu, daß das Lot während des Lötvorganges durch die Kapillarwirkung zwischen dem Kühlblech 101 und dem von diesem Kühlblech 101 beabstandeten Leistungsbauelement 106 eingezogen wird. Dabei wird das Lot in dem Ausführungsbeispiel der Figur 1 von der Seite 111 zwischen das Kühlblech 101 und das Leistungsbauelement 106 eingebracht. Es ist dabei selbstverständlich möglich, das Lot - anstelle der Seite 111 oder auch zusätzlich zur Seite 111 - von einer anderen Seite einzubringen. Bei dem Ausführungsbeispiel der Figur 1 ist weiterhin zu sehen, daß in das Kühlblech 101 ein Loch 110 in dem Teil des Kühlbleches, an dem das Leistungsbauelemente 106 verlötet ist, eingebracht ist und das der Seite 111, an der das Lot eingebracht wird, gegenüber liegt. Dadurch ist eine möglichst weite Entfernung des Loches 110 von der Seite 111 gegeben. Vorteilhaft ist dieses Loch ebenso wie der Bereich 105 veredelt. Durch dieses Loch 110 ist es in einfacher Weise möglich, eine Kontrolle der Verlötung durchzuführen. Für die Wärmeabfuhr ist eine flächige Verlötung wichtig. Mittels des Loches 110 kann die Verlötung überprüft werden, da beim Löten nur dann Lot in dem Loch 110 aufsteigen kann, wenn das Lot flächig zwischen das Leistungsbauelement 106 und das Kühlblech 101 eingezogen wurde. Diese Überprüfung kann dabei mittels einer Sichtkontrolle erfolgen oder auch auf elektrische Weise mittels einer Prüfspitze. Wird dabei das Lot von mehreren Seiten zwischen das Leistungsbauelement 106 und das Kühlblech 101 eingebracht, wird in vorteilhafter Weise die Position des Loches 110 entsprechend geändert, beispielsweise zur Mitte der Fläche des Kühlbleches 101, an der das Leistungsbauelement 106 befestigt wird. Dadurch wird wiederum über einen entsprechend größeren Abstand zu den entsprechenden Seiten die Qualität der flächigen Verlötung kontrollierbar. Ebenso ist es auch denkbar, mehrere Löcher 110 in dem Kühlblech vorzusehen.

Damit eine effiziente Montage ermöglicht wird, ist es sinnvoll, zuerst das Kühlblech auf die Leiterplatte zu bestücken. Dabei wird das Kühlblech an die Leiterplatte 201 herangeführt, derart, daß die Halterungen 104 durch die Löcher 202 der Leiterplatte 201 durchragen. Der gegenüber den beiden Bereichen 102 des Kühlbleches 101 erhobene Bereich 103 schließt dabei bündig mit der Öffnung 204 der Leiterplatte ab. Dadurch ist gewährleistet, daß das Leistungsbauelement bei der nachfolgenden Bestückung mit den Bauteilen auf derselben Höhe positioniert wird wie die übrigen Bauelemente. Eine Befestigung des Kühlbleches erfolgt dabei derart, daß die Halterungen 104, soweit sie aus den Löchern 202 herausragen, verschränkt werden. Durch dieses Verschränken ist zumindest eine erste mechanische Befestigung des Kühlbleches 101 mitsamt dem Leistungsbauelement 106 an der Leiterplatte gegeben.

Im Anschluß daran erfolgt dann das Aufbringen des Leistungsbauelementes im Rahmen der erforderlichen Bestückung. Im Falle einer eventuell anzuwendenden SMD-Bestückungstechnologie wird das SMD-Leistungsbauelement zunächst durch einen SMD-Kleber in der zu verlötenden Position gehalten.

Das Leistungsbauelement 106 wird erfindungsgemäß in Richtung der Leiterplatte versetzt angeordnet und vor dem Löten auf die Leiterplatte aufgeklebt. Dadurch ist eine Fixierung des Leistungsbauelements 106 auch bei einer Verflüssigung der Veredelung des Kühlelements während des Lötvorganges gegeben. Vorteilhaft wird dabei die Metallisierungsfläche des Leistungsbauelements vollständig mit dem Kühlblech 101 verlötet, ohne daß für die Verklebung ein Teil dieser Metallisierungsfläche benötigt wird. Es wird dadurch also ein besonders guter Wärmeübergang erzielt.

Vorteilhaft ergibt sich, daß bei der SMD-Bestückung nur ein Arbeitsgang beim Löten notwendig ist. Das heißt, die elektrische Kontaktierung aller Bauteile dieser Leiterplatte erfolgt in einem Arbeitsgang zusammen mit der wärmeleitenden Befestigung des bzw. der Leistungsbauelemente 106.

Das auf den Bereich 105 aufgelötete Leistungsbauelement 106 ist damit also insgesamt über die Leiterplatte 201 erhaben. Die elektrischen Anschlüsse 107 werden dabei an den dafür vorgesehenen Punkten 203 der Leiterplatte 201 angelötet. In vorteilhafter Weise werden die verschränkten Halterungen 104 zudem noch an der Leiterplatte 201 verlötet, so daß sich eine besonders feste mechanische Verbindung ergibt. Bei dieser Verlötung ist es ebenfalls möglich, das Kühlblech 101 auf ein elektrisches Potential der Leiterplatte 201 zu legen. In besonders vorteilhafter Weise kann dann ein nach außen geführter Leitungsanschluß des Leistungsbauelementes entfallen, wenn dieser elektrische Anschluß dann über die wärmeleitende Befestigung mit dem elektrisch leitenden Kühlblech 101 über die Halterungen 104 mitsamt der Verlötung zu dem entsprechenden elektrischen Potential der Leiterplatte 201 geführt ist. Die in diesem Absatz beschriebenen Verfahrensschritte zur Verlötung können dabei bei einer SMD-Bestückungstechnologie ebenfalls im gleichen Arbeitsgang mit der elektrischen Kontaktierung der übrigen Bauelemente erfolgen.

In vorteilhafter Weise sind weiterhin die Halterungen 104 unmittelbar in dem Bereich 105 vorgesehen, an dem das Leistungsbauelement 106 angelötet ist. Dadurch befinden sich die Befestigungen des Kühlbleches mitsamt dem Leistungsbauelement 106, die eine Verbindung zu der Leiterplatte aufweisen, alle auf derselben Seite. Wenn das Leistungsbauelement also Verlustwärme erzeugt und das Kühlblech mitsamt dem Leistungsbauelement deswegen erwärmt wird und sich dabei ausdehnt, kommen also durch diese schwimmende Befestigung des Kühlbleches mitsamt dem Leistungsbauelement an der Leiterplatte keine mechanischen Spannungen zum Tragen. Die Ausdehnung des Kühlbleches kann also in den Bereichen, in denen das Kühlblech nicht aufgehängt ist, frei erfolgen.

Die Beschreibung der Reihenfolge der Montage erfolgte gemäß den Figuren 1 und 2, um klarzustellen, wie das fertige Produkt aussieht. Für die tatsächliche Reihenfolge der Montage ist es jedoch effizienter, zunächst das Kühlblech an die Leiterplatte zu montieren und anschließend bei der Bestückung der SMD-Bauteile dann nicht nur die Leitungsanschlüsse anzulöten, sondern bei den Leistungsbauelementen gleichzeitig die wärmeleitende Befestigung mit dem Kühlblech durch Löten herzustellen.

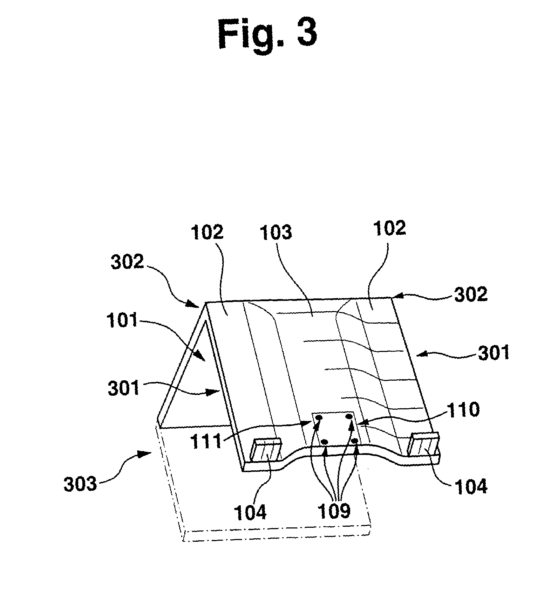

Fig. 3 zeigt eine weitere Ausführungsmöglichkeit für das Kühlblech. Identische Bestandteile tragen bei der Figur 3 dieselben Bezugszeichen wie bei der Fig. 1. Bei dem Kühlblech nach der Fig. 3 ist der erhabene Bereich 103 räumlich begrenzt. Beginnend von der Linie 301 verläuft der erhabene Bereich 103 so, daß er bis zur Linie 302 in einer Ebene mit dem Bereich 102 liegt. Es ist dabei ebenfalls möglich, den erhabenen Bereich 103 kontinuierlich in eine Ebene mit dem Bereich 102 verlaufen zu lassen. Entlang der Linie 302 erfolgt dann eine Abknickung des Kühlbleches 101. In dem Ausführungsbeispiel der Figur 3 ist weiterhinzu sehen, daß ein weiterer Knick 303 vorgesehen ist. Dadurch ist es möglich, unter Beibehaltung einer gewissen Größe des Kühlbleches und einer damit verbundenen hinreichend großen Wärmekapazität und Wärmeabgabefläche dessen Platzbedarf auf der Leiterplatte zu beschränken. Das Kühlblech kann durch die entsprechenden Knicke den Platzverhältnissen auf der Leiterplatte sowie in dem Gerät, in das Leiterplatte eingesetzt werden soll, angepaßt werden.

## Patentansprüche

1. Verfahren zur Befestigung eines elektronischen Leistungsbauelementes (106) an einer Leiterplatte und einem Kühlelement (101), das ein Kühlblech oder ein Kühlkörper sein kann, wobei das Leistungsbauelement (106) an dem Kühlelement (101) flächig angelötet ist,
dadurch gekennzeichnet,
daß das Leistungsbauelement (106) zuerst mit der Leiterplatte verklebt und dann mit dem Kühlelement (101) verlötet wird.

2. Verfahren nach Anspruch 1,
dadurch gekennzeichnet,
daß das Kühlelement (101) zumindest im Bereich der Verbindungsstelle (105) des Kühlelementes (101) mit dem Leistungsbauelement (106) veredelt ist, beispielsweise durch eine Beschichtung mit Zinn, Gold, Silber, Nickel, Palladium, einer zinnhaltigen Legierung wie z.B. Blei-Zinn und/oder wenigstens einem Beschichtungslack.

3. Verfahren nach Anspruch 1 oder 2,
dadurch gekennzeichnet,
daß zumindest während des Lötvorganges wenigstens ein Abstandshalter (109) zwischen dem Kühlelement (101) und dem Leistungsbauelement (106) vorgesehen ist.

4. Verfahren nach einem der Ansprüche 1 bis 3,
dadurch gekennzeichnet,
daß zumindest der Bereich der Verbindungsstelle (105), in dem das Leistungsbauelement (106) mit dem Kühlelement (101) befestigt werden soll, sich auf einer Ebene mit der Bestückungsseite bzw. der Lötseite der Leiterplattenoberfläche befindet.

5. Verfahren nach einem der Ansprüche 1 bis 4,
dadurch gekennzeichnet,
daß das Kühlelement (101) aus Kupfer, Messing, Weißblech oder veredeltem Aluminium besteht.

6. Verfahren nach einem der Ansprüche 1 bis 5,
dadurch gekennzeichnet,
daß das Kühlelement (101) im Zeitpunkt der Verlötung vorgeheizt ist.

7. Verfahren nach einem der Ansprüche 1 bis 6,
dadurch gekennzeichnet,
daß Halterungen (104) des Kühlelementes (101) durch entsprechende Löcher (202) einer Leiterplatte (201) gesteckt und verschränkt werden.

8. Verfahren nach Anspruch 7,
dadurch gekennzeichnet,
daß die Halterungen (104) in dem Bereich der Leiterplatte vorgesehen sind, in dem die elektrischen Anschlüsse (107) des Leistungsbauelements (106) mit der Leiterplatte verlötet sind.

9. Verfahren nach Anspruch 7 oder 8,
dadurch gekennzeichnet,
daß die Halterungen (104) mit der Leiterplatte (201) nach dem Verschränken verlötet sind.

10. Verfahren nach Anspruch 9,
dadurch gekennzeichnet,
daß ein elektrischer Anschluß des Leistungsbauelementes (106) derart realisiert ist, daß über die wärmeleitende Befestigung zugleich ein elektrischer Anschluß des Leistungsbauelementes (106) mit dem Kühlelement (101) realisiert ist und daß das Kühlelement (101) über die Verlötung wenigstens einer der Halterungen (104) mit einem elektrischen Potential der Leiterplatte (201) verbunden ist.

11. Verfahren nach einem der vorhergehenden Ansprüche,
dadurch gekennzeichnet,
daß in dem Kühlelement (101) an einer Stelle, die von der Seite (111), an der das Lot eingebracht wird, entfernt ist und die sich in dem Bereich des Kühlelementes (101) befindet, an dem das Leistungsbauelement (106) verlötet ist, wenigstens ein Loch (110) eingebracht ist.

12. Verfahren nach einem der vorhergehenden Ansprüche,
dadurch gekennzeichnet,
daß das Kühlelement (101) gewinkelt ist (302,303).

## Claims

1. A method of mounting an electronic power component (106) to a printed circuit board and a cooling element (101) which may be a cooling plate or a heat sink, said power component (106) being soldered flat to said cooling element (101),
**characterized by** first joining the power component (106) to the printed circuit board by adhesive bonding and then soldering it to the cooling element (101).

2. The method of claim 1,
**characterized by** finishing the cooling element (101) at least in an area (105) where the cooling element (101) is bonded to the power component (106), said finishing including coating with a material selected from the group consisting of tin, gold, silver, nickel, palladium, a tin-containing alloy as, for example, terne and/or at least an enamel.

3. The method of claim 1 or 2,
**characterized by** providing at least one spacer (109) between the cooling element (101) and the power component (106) at least during the soldering operation.

4. The method of any one of the claims 1 to 3,
**characterized by** aligning at least the bonding area (105) in which the power component (106) is to be attached to the cooling element (101) to be level with the component side or the soldering side of the printed circuit board surface.

5. The method of any one of the claims 1 to 4,
**characterized by** selecting the material of the cooling element (101) from the group consisting of copper, brass, tinplate or processed aluminum.

6. The method of any one of the claims 1 to 5,
**characterized by** heating the cooling element (101) prior to soldering.

7. The method of any one of the claims 1 to 6,
**characterized by** inserting mounting lugs (104) of the cooling element (101) through matching holes (202) in a printed circuit board (201) and folding them over.

8. The method of claim 7,
**characterized by** providing the mounting lugs (104) in the area of the printed circuit board where the electrical leads (107) of the power component (106) are soldered to the printed circuit board.

9. The method of claim 7 or 8,
**characterized by** soldering the mounting lugs (104) to the printed circuit board (201) following folding over.

10. The method of claim 9,
**characterized by** establishing an electrical connection of the power component (106) in such fashion that the thermally conductive mounting establishes at the same time an electrical connection between the power component (106) and the cooling element (101), and by coupling the cooling element (101) to an electrical potential of the printed circuit board (201) through the soldered bond of at least one of the mounting lugs (104).

11. The method of any one of the preceding claims,
**characterized by** providing at least one hole (110) in the cooling element (101) at a location which is remote from the side (111) of solder application and is disposed in that area of the cooling element (101) to which the power component (106) is soldered.

12. The method of any one of the preceding claims,
**characterized by** providing the cooling element (101) with an angled configuration (302, 303).

## Revendications

1. Procédé pour fixer un composant électronique de puissance (106) sur une plaquette à circuits imprimés et sur un élément de refroidissement (101), qui peut être une tôle de refroidissement ou un corps de refroidissement, le composant de puissance (106) étant fixé par brasage selon une certaine surface sur l'élément de refroidissement (101),
caractérisé en ce
que l'on colle tout d'abord le composant de puissance (106) sur la plaquette à circuits imprimés et qu'on le fixe ensuite par brasage à l'élément de refroidissement (101).

2. Procédé selon la revendication 1, caractérisé en ce
que l'élément de refroidissement (101) reçoit une finition au moins dans la zone du point au niveau de la zone de liaison (105) de l'élément de refroidissement (101) au composant de puissance (106), par exemple au moyen d'un revêtement d'étain, d'or, d'argent, de nickel, de palladium, d'un alliage contenant de l'étain, comme par exemple du plomb-étain et/ou au moins une laque de revêtement.

3. Procédé selon la revendication 1 ou 2, caractérisé en ce
qu'au moins pendant le processus de brasage, au moins une entretoise (109) est prévue entre l'élément de refroidissement (101) et le composant de puissance (106).

4. Procédé selon l'une des revendications 1 à 3, caractérisé en ce
qu'au moins la partie de la zone de liaison (105), dans laquelle le composant de puissance (106) doit être fixé à l'élément de refroidissement (101), est situé dans un plan avec la face d'équipement et la face de brasage de la surface de la plaquette à circuits imprimés.

5. Procédé selon l'une des revendications 1 à 4,
caractérisé en ce
que l'élément de refroidissement (101) est réalisé en cuivre, en laiton, en fer-blanc ou en aluminium ennobli.

6. Procédé selon l'une des revendications 1 à 5, caractérisé en ce
que l'élément de refroidissement (101) est préchauffé à l'instant du brasage.

7. Procédé selon l'une des revendications 1 à 6, caractérisé en ce
que des supports (104) de l'élément de refroidissement (101) sont enfichés et emboîtés dans des trous correspondants 202) d'une plaquette à circuits imprimés (201).

8. Procédé selon la revendication 7, caractérisé en ce
que les supports (104) sont prévus dans la zone de la plaquette à circuits imprimés, dans laquelle les bornes électriques (107) du composant de puissance (106) sont fixées par brasage à la plaquette à circuits imprimés.

9. Procédé selon la revendication 7 ou 8, caractérisé en ce
que les supports (104) sont fixés par brasage à la plaquette à circuits imprimés (201), après l'emboîtement.

10. Procédé selon la revendication 9, caractérisé en ce
qu'on réalise simultanément un raccordement électrique du composant de puissance (106) à l'élément de refroidissement (101) par l'intermédiaire de la fixation thermoconductrice et que l'élément de refroidissement (101) est relié à un potentiel électrique de la plaquette à circuits imprimés (200), par l'intermédiaire du brasage d'au moins l'un des supports (104).

11. Procédé selon l'une des revendications précédentes, caractérisé en ce
qu'au moins un trou (110) est aménagé dans l'élément de refroidissement (101) en un emplacement qui est éloigné du côté (111), sur lequel le trou est aménagé et qui est situé dans la zone de l'élément de refroidissement (101), sur laquelle le composant de puissance (106) est fixé par brasage.

12. Procédé selon l'une des revendications précédentes, caractérisé en ce
que l'élément de refroidissement (101) est coudé (302, 303).
